# EUROPEAN PATENT APPLICATION

(11) **EP 0 622 841 A1**
(43) Date of publication of application: **02.11.1994**
(21) Application number: 92924871.4
(22) Date of filing: 02.12.1992
(51) Int. Cl.: H01L 21/68

(54) **METHOD AND APPARATUS FOR TRANSPORTATION OF HIGHLY CLEAN MATERIAL**

(30) Priority: 02.12.1991 JP 343961/91
(71) Applicant: OHMI, Tadahiro, Sendai-shi Miyagi-ken 980 (JP)
(72) Inventor: OHMI, Tadahiro, Sendai-shi Miyagi-ken 980 (JP); MAKIHARA, Koji Dep. of Electronics Faculty of Eng., Sendai-shi Miyagi-ken 980 (JP)
(74) Representative: Weitzel, Wolfgang, Dr.-Ing. Patentanwalt
(86) International application number: JP9201578
(87) International publication number: WO9311560

(57) **Abstract**

A method and apparatus for transportation of wafers from one stage to another in a manufacturing process while protecting clean silicon surfaces and thin films on them from contamination through the air. The apparatus includes a wafer container (101) having a gas inlet (103) and a gas outlet (112), an inert gas container (103) having an inert gas sealed therein, and a piping (114) for connecting the gas inlet (113) of the wafer container to the inert gas container (103) and for sending the inert gas in the inert gas container to the wafer container (114), and wafers are transported while the inside of the wafer container is constantly purged by introducing the inert gas.

## Description

### Technical Field

The present invention relates to a highly clean material transportation apparatus and a material transportation method for transporting materials in a highly clean atmosphere, and in particular relates to a highly clean material transportation apparatus and a material transportation method which is capable of protecting substrates from impurities in the air and is capable of maintaining a constant highly clean state of the substrate surfaces, during the transportation of substrates in semiconductor manufacturing processes and the like.

### Background Art

In accordance with recent progress in LSI microprocessing technologies and cleaning technologies, concern has grown over adhering impurities and natural oxide films present on silicon surfaces, and the complete control of silicon surfaces is of increasing importance in view of the establishment of processes having higher performance.

For example, in order to control selective reactions such as etching or film formation or the like with high precision, or to realize ideal boundaries between different materials, it is most important that the deposition of impurities on silicon surfaces and the formation of natural oxide films be suppressed, and that ultra-clean silicon surfaces be obtained. In order to completely suppress such depositing of impurities or formation of natural oxide films, and in order to obtain ultra-clean silicon surfaces, it is necessary that the deposition of impurities on the wafer surface be completely prevented during the period of, for example, the completion of the final washing process of the silicon wafers to the positioning of the wafers within the ultra-clean processing apparatus of the subsequent process, or while the wafers are being moved among processing apparatuses.

Conventionally, in order to obtain ideal silicon surfaces, energetic attempts have been made to improve the purity of the chemicals, pure water, or the like employed during wet washing. As a result, it has become possible to obtain surfaces on which the presence of impurities or natural oxide films is reduced in the extreme during wet washing; however, as silicon surfaces are extremely active, during subsequent transport to the processing apparatuses of following processes, problems occurred in that the wafers came into contact with the air and surfaces which had been rendered clean were again contaminated, and natural oxide films formed thereon.

Furthermore, in order to obtain ideal boundaries between differing materials, as well, the ability to conduct subsequent processes while maintaining a clean surface has been desired. However, it is presently the case that during transport between apparatuses, wafers come into contact with air, and the surfaces thereof become contaminated. To state one example, in the case in which Schottky junctions are formed between metal and silicon, when the wafers are transported in the presence of air, impurities are deposited, or natural oxide films form, on the surface of the silicon wafers, so that ideal metal-silicon boundaries cannot be obtained, and the Schottky barrier height characteristics worsen.

Furthermore, it is currently the case that even after a metal film is formed on a silicon wafer, when the wafer is transported through air, the metal surface oxidizes rapidly, so that problems are caused in subsequent processes.

In light of the above circumstances, the present invention has as an object thereof to provide a highly clean material transportation apparatus and material transportation method which are capable of protecting silicon substrate surfaces or surfaces on which various thin films are formed from contamination through the air, and which are capable of transporting these to subsequent processing apparatuses while maintaining highly clean surfaces.

### Disclosure of the Invention

A first essential feature of the present invention resides in a highly clean material transportation apparatus which is an apparatus for transporting material in a highly clean state, characterized in being provided with: a wafer container possessing a gas inlet and a gas outlet, an inert gas container having an inert gas sealed therein, and a piping system connecting the gas inlet and the inert gas container, and serving the purpose of transporting the inert gas within the inert gas container to the material container.

A second essential feature of the present invention resides in a material transportation method, characterized in that wafers are placed in a wafer container possessing a gas inlet and a gas outlet, an inert gas is sent to the wafer container from the inert gas container via the piping system and the gas inlet, and the inert gas is expelled from the gas outlet and the wafers are transported while the inside of the wafer container is constantly purged with inert gas.

### Function

The transportation apparatus of the present invention is provided with a container, the inner atmosphere of which can be replaced, and a high purity inert gas container, and the highly pure inert gas is constantly supplied to the interior of the container, so that it is possible to maintain the interior of the container in a highly pure inert gas atmosphere, and it is thus possible to conduct transportation without causing the formation of natural oxide films or the deposition of impurities on the surfaces of semiconductors or metals or the like.

Furthermore, the transportation apparatus of the present invention is provided with connectors to other processing apparatuses and with a preliminary chamber, and an inert gas inlet and outlet are provided in the preliminary chamber, so that even when wafers are placed in the processing apparatus, the semiconductors or metallic surfaces are not exposed to the air, and it is possible to conduct operations in an ultra-clean inert gas atmosphere. As a result, it is possible to constantly maintain the wafer surfaces in a highly clean state, so that highly precise etching and film formation become possible, and furthermore, it is possible to realize ideal boundaries.

### Embodiment Examples

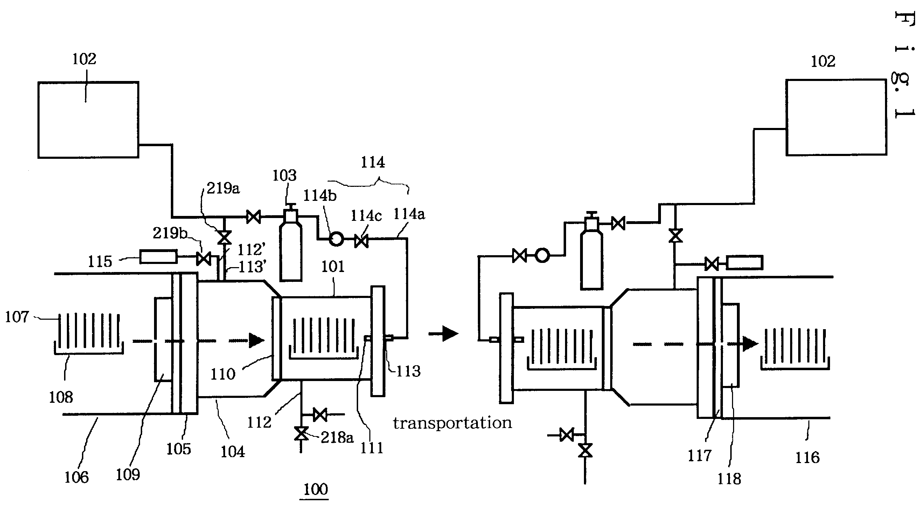

Herein below, embodiment examples of the present invention will be explained using the Figures. Fig. 1 shows a structural example of the present invention; it depicts a method for transporting semiconductors from a semiconductor washing apparatus to a subsequent processing apparatus, which employs the transportation apparatus of the present invention.

Wafer transportation apparatus 100 comprises a wafer container 101, a piping system 114 comprising piping 114a, pressure-reducing valve 114b, and valve 114c, and inert gas container 103. Gas inlet 113 and gas outlet 112 are attached to wafer container 101 in order to permit the replacement of the inner atmosphere thereof, and furthermore, a connector 105 is attached to the wafer container 101 in order to connect this to other apparatuses via preliminary chamber 104. Gas inlet 113' and gas outlet 112' are provided in preliminary chamber 104 in order to permit the replacement of the inner atmosphere thereof. Furthermore, preliminary chamber 104 and wafer container 101 are divided by means of door 110.

First, a method in which wafers are placed in wafer transportation apparatus 110 from semiconductor washing apparatus 106 will be explained. Connector 105 of wafer transportation apparatus 110 is attached to the connector of semiconductor washing apparatus 106, and an inert gas is supplied to wafer container 101 from inert gas (for example, nitrogen gas, Ar gas, or the like) supply apparatus 102, via inert gas container 103, stainless steel piping system 114, and gas inlet 113, this gas is discharged from gas outlet 112, and the atmosphere within the container is replaced with a highly pure gas atmosphere. In the same manner, inert gas is supplied to preliminary chamber 104 via valve 219a and gas inlet 113', and the interior thereof is placed in a highly pure gas atmosphere.

At this time, the gas replacement of the preliminary chamber and the interior of the wafer container need not be conducted separately; for example, it is acceptable to conduct this replacement by introducing inert gas from the gas inlet 113 of the wafer container in the state in which door 110 is open, and discharging this gas from gas outlet 112' of the preliminary chamber. Furthermore, it is also possible to connect the gas outlet 112' of the preliminary chamber to a vacuum pump 115 prior to introducing the gas, and the place the interior thereof in a vacuum.

After the atmosphere within wafer container 101 and preliminary chamber 104 has been made ultra-clean, the semiconductor entry and exit port 109 of semiconductor washing apparatus 106 and the door 110 of wafer container 101 are opened. Next, semiconductors 107, which are set on a semiconductor fixing cartridge 108, are conveyed into wafer container 101, and door 110 of the wafer container is closed. During this, an inert gas is continually introduced into the wafer container 101 and the preliminary chamber 104.

After the semiconductor devices 107 have been introduced into wafer container 101, wafer transportation apparatus 100 is detached from inert gas supply apparatus 102 and semiconductor washing apparatus 106, and is transported to the apparatus of the subsequent process. During this transportation, an inert gas is supplied to the interior of the wafer container 101 from inert gas container 103, and this gas is constantly discharged from gas outlet valve 218.

Furthermore, a plurality of gas release ports are provided in a gas release pipe 111 within wafer container 101 so as to release gas in a direction perpendicular with respect to the gas release pipe 111. These discharge ports may be provided irregularly; however, it is preferable that they be provided in rows of holes having equal spacing. In this case, it is preferable that three or more rows of holes be present, and four or more rows is further preferable. By providing four or more rows, the gas exchange efficiency is further increased.

Furthermore, at this time, it is preferable that the flow rate of the nitrogen gas be such that the atmosphere within the wafer container be replaced once each minute. Furthermore, the inert gas pressure within the inert gas container is within a range of approximately 50-150 kg/cm².

After being conveyed through the cleanroom, the connector 105 of the wafer transportation apparatus 100 is attached to the connector 117 of a processing apparatus 116 (for example, a metal sputtering apparatus) of a subsequent process, and after the atmosphere of preliminary chamber 104 is exhausted by means of vacuum pump 115, inert gas is supplied from inert gas supply apparatus 102 via gas inlet valve 211a and gas inlet 113', and preliminary chamber 104 is placed in a highly clean atmosphere.

Next, the semiconductor entry and exit port 118 of sputtering apparatus 116, and door 110 of wafer container 101, are opened, and semiconductors 107 are conveyed within sputtering apparatus 116 by semiconductor fixed cartridges 108 within wafer container 101.

The transportation apparatus of the present invention has the structure described above, so that while semiconductors 107 are being transported from apparatus to apparatus, they are not exposed to air, and furthermore, the impurities present in air do not adhere to the surface of the semiconductors. Furthermore, the highly pure inert gas within wafer container 101 is constantly purged even during transportation, so that transportation is possible without causing deterioration such as the formation of natural oxide films or the like on the surface of the semiconductors or on the metallic surfaces on which a film has been formed.

It is preferable that light-weight Al be employed as the material for wafer container 101; however, the material thereof is not limited to Al.

### Brief Description of the Drawings

Fig. 1 is a conceptual diagram showing a structural example of the highly clean material transportation apparatus of the present invention.

Fig. 2 is a graph showing the relationship between the barrier height of the Schottky diode and surface area.

Fig. 3 is a graph showing the current-voltage characteristics of the Schottky diode.

Fig. 4 is a graph showing the dependency of contact resistance on surface area.

### (Description of the References)

100 wafer transportation apparatus
101 wafer container
102 inert gas supply apparatus
103 inert gas container
104 preliminary chamber
105 connector between wafer container and other apparatuses
106 semiconductor washing apparatus
107 semiconductor (wafer)
108 semiconductor fixing cartridge
109 semiconductor entry and exit port
110 door of wafer container
111 gas release pipe
112 gas outlet of wafer container
113 gas inlet of wafer container
112' gas outlet of preliminary chamber
113' gas inlet of preliminary chamber
114 piping system
114a piping (stainless steel)
114b pressure reducing valve
114c valve
115 vacuum pump
116 sputtering apparatus
117 connector of sputtering apparatus
118 semiconductor entry and exit port
211 valve
218 gas outlet valve of wafer container
219a gas inlet valve of preliminary chamber
219b gas outlet valve of preliminary chamber

### Best Mode for Carrying Out the Invention

Hereinbelow, an embodiment of the present invention will be given.

Silicon wafers having n-type and p-type (100) and (111) surfaces were washed, and then, using the transportation apparatus shown in Fig. 1, these were transported to a RF-DC junction-type bias sputtering apparatus, various metallic thin films were formed thereon, and ohmic contacts and Schottky diodes were formed.

The wafer container comprised Al, had a weight of 1200 g, and the total weight of the apparatus, including the piping system and the inert gas container, was is 7 kg. Furthermore, the volume thereof was 1500 cc. During transportation, 2 l/min of nitrogen gas having a moisture concentration of less than or equal to 10 ppb was supplied, and the interior of the wafer transportation apparatus was constantly maintained in a highly clean atmosphere.

For the purposes of comparison, silicon wafers which had been transported through the air in the conventional manner without the use of the transportation apparatus of the present embodiment had ohmic contacts and Schottky diodes formed thereon in an identical manner, and a comparison was made of the contact resistances and diode characteristics and the like thereof.

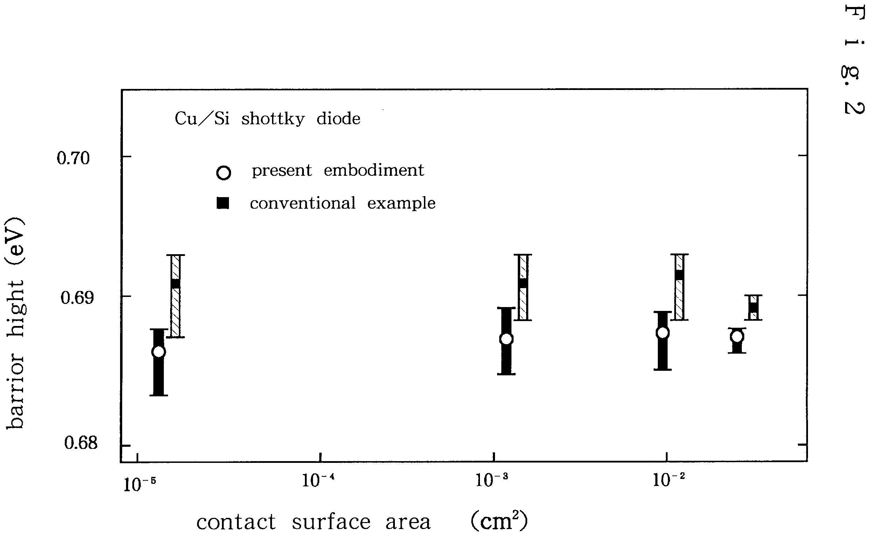

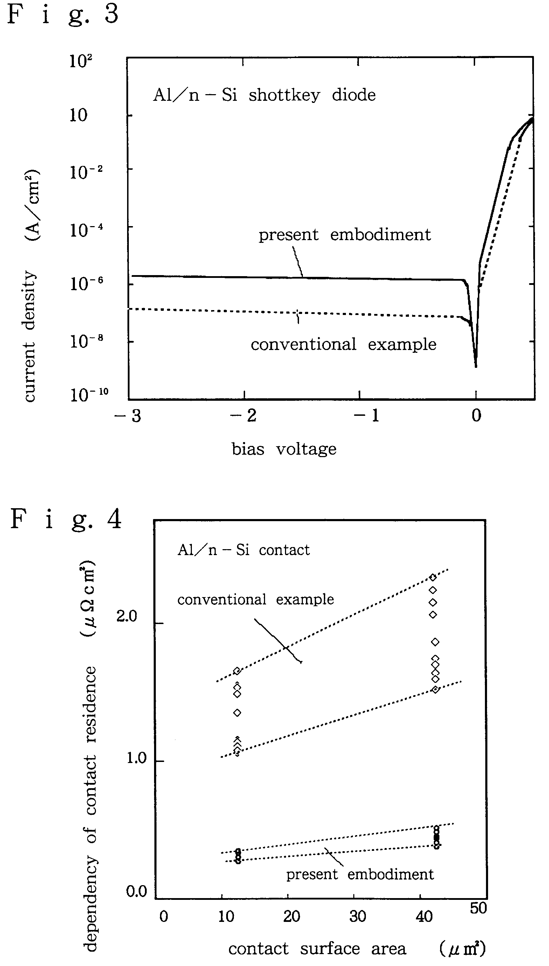

In Fig. 2, the relationship between the barrier height of the Cu/n-Si Schottky diode and the junction surface area is shown, and furthermore, the current/voltage characteristics of the Al/n-Si are shown in Fig. 3. As is clear from Fig. 2, in comparison with the conventional diode, in the present embodiment, a diode having a smaller barrier height was obtained. Furthermore, as shown in Fig. 3, the inverse saturation current density is larger in the present embodiment.

This is thought to result from the fact that, in the conventional example, a natural oxide film is formed at the Si surface during wafer transportation, and a natural oxide film is present at the metal-silicon boundary, so that the Schottky barrier apparently becomes larger. In contrast, in the present embodiment, the formation of a natural oxide film is suppressed during the wafer transportation process, and thus the cleanness of the surface is thought to be maintained after washing.

Next, the n-type and p-type (100) and (111) silicon wafers produced in accordance with the present embodiment, and the Schottky barrier heights of Cu, Al, and Ti, are shown in Table 1.

**TABLE 1**

| | (100) Si | | | (111) Si | | |
|---|---|---|---|---|---|---|
| | Al | Cu | Ti | Al | Cu | Ti |
| Φₙₚ | 0.837 | 0.680 | 0.551 | 0.821 | 0.727 | 0.528 |
| Φ_{bp} | | 0.470 | 0.607 | | 0.506 | 0.634 |
| Φ_{bn}+Φ_{bp} | | 1.150 | 1.158 | | 1.233 | 1.162 |

In the table, Φ_{bn} and Φ_{bp} indicate the barrier heights between the silicon and the metal in the n-type and p-type, respectively. When ideal Schottky junctions are formed, the value of Φ_{bn} + Φ_{bp} is 1.2 eV; however, as is clear from the table, it was discovered that values close to those of the ideal state were obtained by following the method of the present embodiment.

Next, the dependency of the contact resistance of the Al/n⁺ - Si on surface area is shown in Fig. 4. In comparison with a wafer which is transported through the air, the contact resistance of a wafer which was transported using the apparatus of the present embodiment has a lower value, and it was thus learned that there was almost no dependency on surface area. Furthermore, dispersion of the contact resistance was greatly limited.

As described above, by using the transportation apparatus of the present embodiment, it is possible to prevent the contamination by the air of the surface of silicon wafers, and to transport these wafers to subsequent processes while maintaining clean surfaces.

### Industrial Applicability

In accordance with the present invention, semiconductors or metallic surfaces are not exposed to the air, so that it is possible to maintain a highly clean surface state. As a result, it is possible to provide a highly clean wafer transportation apparatus and wafer transportation method which permit highly precise etching and film formation, and which realize an ideal boundary between differing materials.

## Claims

1. A highly clean material transportation apparatus for transporting material in a highly clean state, characterized in being provided with:
a wafer container possessing a gas inlet and a gas outlet,
an inert gas container having an inert gas sealed therein, and
a piping system connecting the gas inlet and the inert gas container, and serving the purpose of transporting the inert gas within the inert gas container to the wafer container.

2. A highly clean wafer transportation apparatus in accordance with claim 1, characterized in that in said wafer container, a connector which can be connected to other apparatuses is provided.

3. A highly clean wafer transportation apparatus in accordance with claim 2, characterized in that a preliminary chamber is provided between said wafer container and said connector, and a gas inlet and a gas outlet are provided in said preliminary chamber.

4. A highly clean wafer transportation apparatus in accordance with one of claims 1 through 3, characterized in that a gas release pipe for releasing said inert gas introduced from said gas inlet of said wafer container into an interior of said wafer container is provided in the interior of said wafer container, and a plurality of gas release ports are provided in at least one of the longitudinal direction and the circumferential direction of said gas release pipe.

5. A highly clean wafer transportation apparatus in accordance with one of claims 1 through 4, characterized in that said wafer container comprises aluminum.

6. A highly clean wafer transportation apparatus in accordance with one of claims 1 through 5, characterized in that all piping, valves, and pressure reducing valves employed in said piping system comprise metal.

7. A highly clean wafer transportation apparatus in accordance with one of claims 1 through 6, characterized in that said inert gas comprises nitrogen or argon gas.

8. A material transportation method, characterized in that
wafers are placed in a wafer container possessing a gas inlet and a gas outlet,
an inert gas is sent to the wafer container from the inert gas container via said piping system and said gas inlet, and
said inert gas is expelled from said gas outlet and wafers are transported while the interior of said wafer container is constantly purged with inert gas.

9. A material transportation method in accordance with claim 8, characterized in that in said wafer container, a connector which can be joined to other apparatuses is provided, said connector is attached to other apparatuses, and the delivery of wafers between said other apparatuses and said wafer container is conducted, without exposing wafers to the air.

10. A wafer transportation method in accordance with claim 9, characterized in that, between said wafer container and said connector, a preliminary chamber possessing an inert gas inlet and outlet is provided, and prior to the transfer of wafers between said wafer container and said other apparatuses, the gas purging, or the evacuation and gas purging, of said preliminary chamber is conducted.

11. A wafer transportation method in accordance with claim 8, characterized in that a flow rate of said inert gas is greater than or equal to a volume of said wafer container per minute.

12. A wafer transportation apparatus in accordance with one of claims 8 through 11, characterized in that said inert gas comprises Ar or nitrogen gas.
